Europäisches Patentamt

European Patent Office

Office européen des brevets

(11) Publication number: **0 037 040**
**B1**

(12) **EUROPEAN PATENT SPECIFICATION**

(45) Date of publication of patent specification: **15.01.86**

(51) Int. Cl.⁴: **H 01 L 21/00**

(21) Application number: **81102119.5**

(22) Date of filing: **20.03.81**

(54) **Method of manufacturing a semiconductor device.**

(30) Priority: **29.03.80 JP 40678/80**
**29.03.80 JP 40679/80**

(43) Date of publication of application:
**07.10.81 Bulletin 81/40**

(45) Publication of the grant of the patent:
**15.01.86 Bulletin 86/03**

(84) Designated Contracting States:
**DE FR GB**

(56) References cited:
**DE-A-2 636 351**

**IBM TECHNICAL DISCLOSURE BULLETIN, vol. 20, no. 11B, April 1978, NEW YORK (US), G.A. BROOKS et al.: "Planar lift-off process", pages 4805-4806**

**SOLID STATE TECHNOLOGY, vol. 13, no. 6, June 1970, PORT WASHINGTON (US), Multiple-mask chemical etching, page 65**

(73) Proprietor: **VLSI Technology Research Association**
**4-28, Mita 1-chome Minato-ku**
**Tokyo 108 (JP)**

(72) Inventor: **Menjo, Atsuhiko**
**952 Bukko-cho Hodogaya**
**Yokohama-shi (JP)**
Inventor: **Shinozaki, Satoshi**
**1245 Koyama-cho Midori-ku**
**Yokohama-shi (JP)**

(74) Representative: **Henkel, Feiler, Hänzel & Partner**
**Möhlstrasse 37**
**D-8000 München 80 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a method of manufacturing a semiconductor device and, more particularly, a method of manufacturing a semiconductor device in which the step of forming an interconnection electrode by the lift-off has been improved.

As the semiconductor device is integrated more and more highly these days, it becomes needed that the space between interconnection electrodes is reduced and that the multi-layer interconnection technique is improved. Interconnection electrodes are formed by the lift-off to meet such need. The lift-off has various merits that line width is not reduced and no consideration is needed to pay for the etching of metal since the metal layer itself is not etched and that the end of the interconnection electrode formed is slanted suitable for use in multi-layer interconnection.

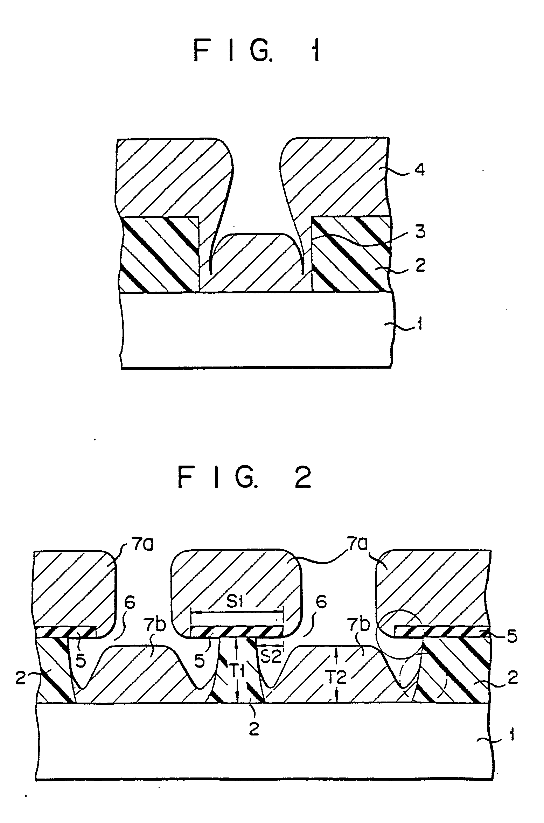

The manner of forming the interconnection electrode by the conventional lift-off comprises, as shown in Fig. 1, coating a photoresist film 2 having a predetermined pattern on a substrate 1, heaping up a metal layer 4 on the whole surface thereof including a hole 3 in which an electrode is to be formed, removing the photoresist film 2 to lift-off the metal layer 4 on the photoresist film 2, and leaving the metal layer 4 residual in the electrode forming hole 3. However, this manner has such drawback that when the metal layer 4 is deposited by the depositing method of excellent step coverage, metal is deposited on the inner wall of the hole 3 of the photoresist film 2, as shown in Fig. 1, to make the lift-off impossible.

In order to improve the above manner, another measure of reliably separating the metal layer is carried out by forming a film for forming overhangs thereunder on the photoresist film which serves as lift-off material. As shown in Fig. 2, the photoresist film 2 is coated as lift-off material on the substrate 1 and after a film for forming overhangs is heaped up on the photoresist film 2, it is patterned to form a pattern 5. The photoresist film 2 is then overetched using the pattern 5 as mask to form holes 6 for forming interconnection electrodes and overhangs under the pattern 5. Thereafter, metal is deposited on the whole surface thereof. This second manner never fails to break off the metal layer at the portion enclosed by a circle of solid line in Fig. 2 to separate a metal layer 7a on the pattern 5 from a metal layer 7b in a hole 6, thus making the lift off of the metal layer 7a possible by the late removal of the photoresist film 2.

However, when the photoresist film 2 which serves as lift-off material is removed in the second manner, metal adheres like flash to the lower wall portion of the hole 6, as shown by a circle of dotted line in Fig. 2, and pieces falling off from the flash in the successive process gives bad effect to the performance of the semiconductor device.

When etching of the photoresist film 2 is carried out by isotropic etching using the pattern 5 as mask at the time of forming overhangs by the lift-off, the following condition must be met not to remove the pattern 5 from on the photoresist film 2. Namely, providing that the minimum interval of the interconnection electrode be $S_1$ and the thickness of the photoresist film $T_1$, undercut width $S_2$ at the time of etching the photoresist film 2 will be equal substantially to $T_1$ and it must be therefore that $S_1>2T_1$. In addition, providing that the thickness of metal layers 7a and 7b be $T_2$, it must be that $T_1>T_2$ so as to easily achieve the lift-off. Therefore, it must be that $S_1>2T_2$. As the result, when the thickness of the interconnection electrode is determined, the minimum interval of the interconnection electrode is determined at the same time, thus hindering the interval reduction of the interconnection electrode and the high integration of the circuit.

An object of the present invention is to provide a semiconductor device manufacturing method capable of forming fine interconnection electrodes and no-breaking interconnection to produce a semiconductor device of high reliability and integration.

Another object of the present invention is to provide a method of manufacturing a semiconductor device having excellent surface stability.

According to the present invention, a semiconductor device manufacturing method is provided comprising forming an insulating film on the main surface of a semiconductor substrate, parts of the insulating film being selectively removed to form through-holes, depositing a glass layer on the insulating film and in the through-holes, the glass layer having multi-layer structure consisting of at least two layers and in which etching rate becomes higher from the lower to the upper portions of the layer, coating a desired portion of the glass layer, where no interconnection electrode is to be formed, with a resist film, over-etching the glass layer to make the resist film overhung using the resist film as mask and to provide contact holes in the glass layer, forming a conductive layer (116a, 116b) on the whole surface of the structure so obtained, and removing the resist film (114) and lifting-off the portions of the conductive layer (116a) on the resist film (114) to thereby form an interconnection electrode.

According to the present invention, a semiconductor device manufacturing method is further provided comprising forming a selectively removed insulating film on a main surface of a semiconductor substrate, depositing a glass layer on the insulating film, gettering in such a way that the thus formed substrate is exposed in an atmosphere containing $POCl_3$ of high temperature, removing the surface portions of the glass layer by etching, coating a desired portion of the glass layer with a resist film, overetching the glass layer to make the resist film overhung using the resist film as mask, forming a conductive layer on the whole surface thereof, and removing the resist film by etching and lifting-off portions of the conductive layer on the resist film to thereby make an interconnection electrode.

This invention can be more fully understood from the following detailed description when taken in conjunction with the accompanying drawings, in which:

Fig. 1 is a sectional view showing a metal layer deposited by the conventional lift-off;

Fig. 2 is a sectional view showing the metal layer deposited by the conventional lift-off in which overhang structure is employed;

Fig. 3 is a sectional view showing the upper edge portion of a glass layer controlled according to the present invention; said glass layer being used as spacer for the lift-off;

Figs. 4A through 4C are sectional views showing the process of manufacturing a bipolar integrated circuit according to a first embodiment of the present invention; and

Figs. 5A and 5B are sectional views showing the process of manufacturing a bipolar integrated circuit according to a second embodiment of the present invention.

A first embodiment of the present invention will be now described following the steps of process successively.

An insulating film is coated on a main surface of a semiconductor substrate by the thermal oxidation or CVD (chemical vapor deposition) method and a part of this insulating film is selectively removed to form an opening section such as contact hole. A glass layer is then deposited by the vapor growth method or the like on the insulating film which includes the opening section. This glass layer serves as spacer in the lift-off method and is left residual after lift-off to make the semiconductor device flat. It is necessary to form the glass layer in multi-layer structure having at least two layers in such a way that the etching rate becomes higher as it goes to the upper portion, because it is possible to positively form the overhang of a resist layer at the time of etching the glass layer using the resist layer as mask. In order to form the glass layer in multi-layer structure are employed, for example, the method of multi-layer depositing the impurity-added glass layer in such a manner that impurity concentration becomes higher as it goes to the upper portion. Phospho silicate glass (PSG), arseno silicate glass (AsSG), boro silicate glass (BSG) and the like are cited, for example, as impurity-added glass. It is desirable to make the glass layer thicker than a metal layer which will be deposited layer. When the impurity-added glass layer is deposited on the insulating film, the glass layer contacts through the opening section of the insulating film with an impurity region already formed on the semiconductor substrate. When the conductivity type of impurity contained in the glass layer is reverse this time to that of impurity in the impurity region, bad effect is caused in the impurity region. It is desirable in this case to deposit a thin no-impurity-added glass layer such quartz glass layer on the insulating film prior to deposition of impurity-added glass layer.

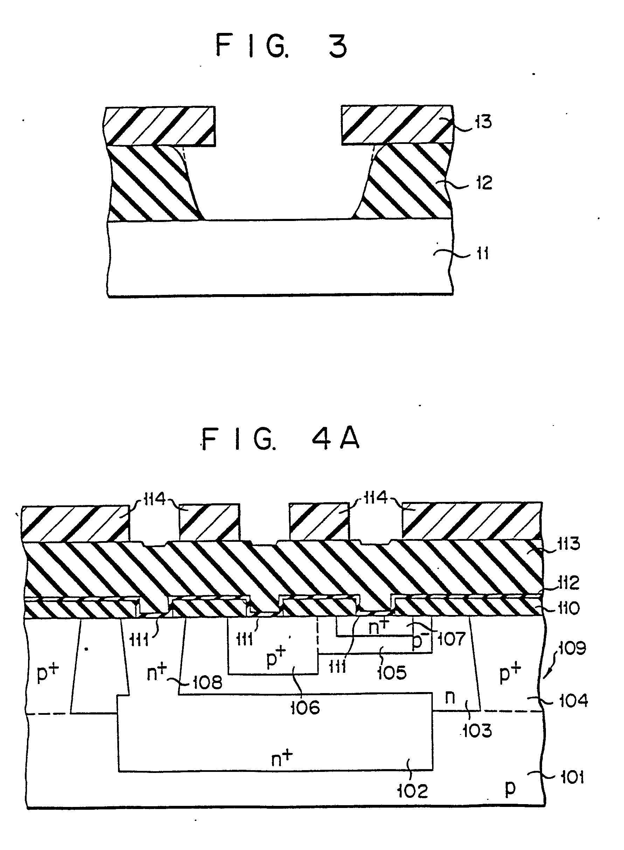

After the resist film is coated on a desired portion of the glass layer, that is, the portion except when an interconnection electrode is to be formed, the glass layer is etched using the resist film as mask. When this etching is carried out by the isotropic etching such as wet etching, the glass layer is provided with holes for the interconnection electrode and over-etched to form the overhang of the resist film. The resist film which is employed in the present invention may be photoresist responsive to ultra-violet rays or ionizing radiation sensitive resist responsive to ionizing radiation such as X-rays and electron rays. It may be of positive or negative type. As the glass layer is made up multi-layer structure in which etching rate becomes higher as it goes to the upper portion as described above, the upper edge portion of the glass layer 12 can be controlled to have shapes as shown by solid lines in Fig. 3 by appropriately adjusting the etching rate in the upper portion of the glass layer 12. The same result is obtained by the following another method. The method of exposing the glass layer surface in gas plasma of a gas mixture such as $CF_4$ and $O_2$ after deposition of impurity-added glass layer to thereby reform the glass layer in such a way that etching rate becomes higher as it goes to the surface. According to the control of shapes of the upper edge portion by the two methods as described above, bad effect exerted to interconnection electrodes present higher than the second layer because of shapes of the upper edge portion of the glass layer which is left residual after the lift-off step can be eliminated. Both of anisotropic etching represented by reactive ion etching (RIE) and isotropic etching represented by wet etching may be used together to etch the glass layer. The use of both anisotropic and isotropic etchings makes it possible to select the length $S_2$ of undercut shown in Fig. 2 regardless of the film thickness of the spacer (glass layer), said length of undercut being a problem in the conventional methods. As the result, since the minimum interval of the interconnection electrode may meet the relation of $S_1 > 2S_2$, the interval of the interconnection electrode can be determined regardless of thicknesses of the spacer and interconnection electrode, thus allowing the pitch of the interconnection electrode to be reduced.

After a conducting layer is deposited on the whole surface including the resist film by vacuum or sputtering deposition, the resist film is removed by etching. The conductive layer on the resist film is also lifted off at the same time to form the interconnection electrode contacted with the semiconductor substrate through the opening section of the insulation film. As the conductive material to form the interconnection electrode are cited Al; Al alloy such as Al-Si, Al-Cu and Al-Si-Cu; poly-Si; impurity-doped poly-Si; metal silicide such as molydenum silicide, tungsten silicide and tantalum silicide; molybdenum; tantalum; and titanium.

An insulating layer is then deposited on the glass layer and the interconnection electrode enclosed by the glass layer and, if necessary, a second layer of interconnection electrode is further formed on the deposited insulating layer, thus finishing the manufacture of a semiconductor device.

According to the method of the present invention as described above, the glass layer is used as spacer for the lift-off step, the resist film provided with the overhang above the spacer is used as lift-off material, and the glass layer is left residual after the lift-off step. Accordingly, fine and no-opening multi-layer interconnection can be formed and a semiconductor device of high integration and reliability can be manufactured.

Another embodiment of the present invention will be now described.

The technique of forming elements has been improved as the semiconductor device is more highly integrated to form a shallow junction in the semiconductor substrate. However, this shallow junction causes the difficulty of diffusing phosphorus into the semiconductor substrate at the time of phosphorus gettering. If phosphorus gettering is carried out in this case after deposition of the glass layer in the first embodiment of the present invention, the glass layer will prevent phosphorus from being diffused into the semiconductor substrate. Namely, the glass layer serves as spacer in the lift-off step and to also prevent phosphorus from being diffused into the substrate at the time of gettering. It is desirable in this case that the glass layer is made thicker than the film thickness of the conductive layer which will be deposited later, so that phosphorus may not be diffused into the semiconductor substrate at the time of phosphorus gettering.

Phosphorus gettering is carried out exposing the substrate in an atmosphere containing $POCl_3$ of high temperature ranging from 900°C to 1,000°C, for example, after deposition of the glass layer. Alkali metal present in the semiconductor substrate, insulating film or glass layer is gettered by such phosphorus gettering to the surface portion of the glass layer. The glass layer containing highly-concentrated phosphorus in the surface portion thereof is removed by etching after phosphorus gettering so as to prevent re-diffusion of gettered alkali metal.

Other steps following the step of coating the resist film on the desired portion of the glass layer are same as those in the first embodiment.

As described above, surface stability of the semiconductor device can be realized and a semiconductor device of high reliability and integration can be manufactured by using the glass layer as layer for preventing phosphorus from being diffused into the semiconductor substrate at the time of phosphorus gettering.

There will be now described an example in which the present invention is employed in the manufacture of bipolar integrated circuits.

Example 1

(I) As shown in Fig. 4A, an $n^+$-buried layer 102 was selectively formed in a p-type silicon substrate 101 and, after an n-type epitaxial layer 103 was grown on the substrate 101, boron of high concentration was selectively diffused into the n-type epitaxial layer 103 to form a $p^+$-type isolation region 104 for separating element regions. $n^+$-type collector region 108 which reached the $n^+$-buried layer 102 was formed by phosphorus diffusion. p-type internal base region 105 and $p^+$-type external base region 160 were formed by selectively implanting boron ions into the element regions of the n-type epitaxial layer 103, while $n^+$-type emitter region 107 was formed by implanting arsenic ions into the internal base region 105, thus making a semiconductor substrate 109. An $SiO_2$ film 110 was then coated as insulating film on the main surface of this semiconductor substrate 109 by the CVD method and after the $SiO_2$ film was further removed from the base region 106, emitter region 107 and collector region 108 by photoetching to form contact holes 111, an impurity-undoped glass layer 112 ($SiO_2$ layer) was heaped up on the whole surface thereof by the vapor growth method to have a thickness of 50 nm (500 Å). Thereafter, a phosphorus-doped glass layer 113 (PSG layer) was heaped up on the $SiO_2$ layer 112 by the vapor growth method to have a thickness of about 1.1 µm and higher phosphorus concentration as it goes to the upper portion, and a photoresist film 114 whose thickness was 1.0 µm and which was formed by photolithography was coated on the PSG layer 113 on its portion except where interconnection electrode was to be formed.

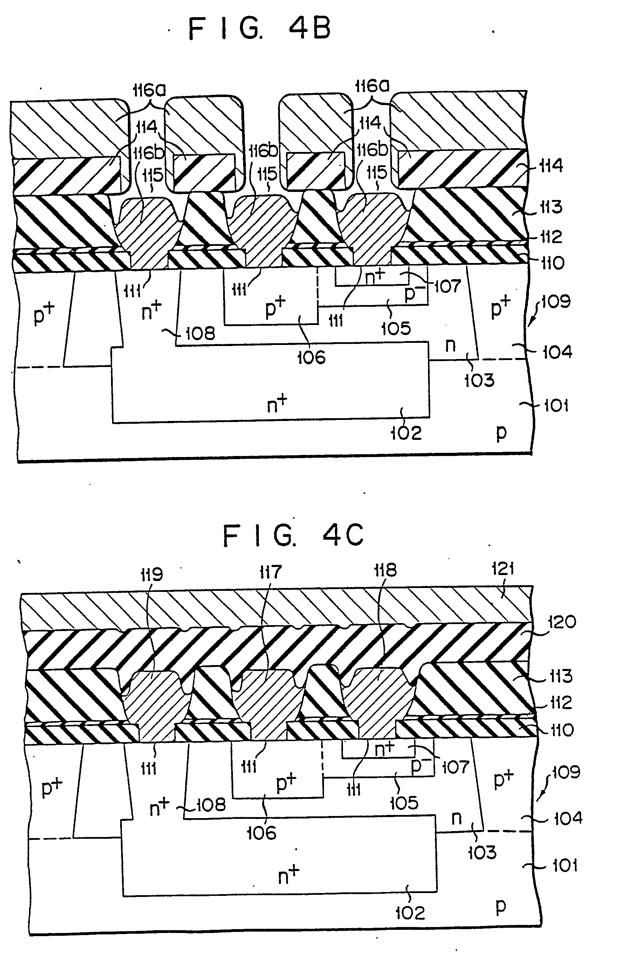

(II) After the PSG layer 113 was etched by the use of both RIE (anisotropic etching) and wet etching (isotropic etching) methods using the photoresist film 114 as mask, an Al-Si alloy layer whose thickness was about 1 µm was heaped up thereon by vacuum deposition (see Fig. 4B). The PSG layer 113 and $SiO_2$ layer in contact holes 111 were selectively removed to form holes 115 in which interconnection electrode was to be arranged, and the PSG layer 113 was also undercut to make the edge of the photoresist layer 114 overhung. The Al-Si alloy layer 116a heaped up on the photoresist layer 114 was made discontinuous and separated from the Al-Si alloy layer 116b present near each of contact holes 111 in interconnection electrode forming holes 115 at the time of heaping the Al-Si alloy layer because the photoresist film 114 was overhung above the opening of each of interconnection electrode forming holes 115.

(III) The photoresist film 114 was then etched off. The Al-Si alloy layer 116a on the photoresist film 114 was lifted off at this time to form Al-Si interconnection electrodes 117, 118 and 119 for the base, emitter and collector as shown in Fig. 4C, said interconnection electrodes comprising the residual Al-Si alloy layer contacted at its edge portions with inner walls of holes 115 of the residual PSG layer 113 and connected through contact holes 111 to the regions 106, 107 and 108 of the semiconductor substrate. Thereafter, an insulating film 120 for insulating adjacent interconnection electrode layers was heaped up on the PSG layer 113 and Al-Si interconnection electrodes 117, 118 and 119 enclosed by the PSG layer 113, and an Al interconnection electrode 121 was further formed as a second layer on the layer-insulating film 120, thus making a bipolar integrated circuit.

In the above-described example, the Al-Si alloy layer 116a on the photoresist film 114 could be reliably made discontinuous and separated from the Al-Si alloy layer 116b in each of interconnection electrode forming holes 115 of the PSG layer 113 at the time of heaping the Al-Si alloy layer and lift-off of the Al-Si alloy layer could be achieved easily using the PSG layer 113 as spacer and the photoresist film 114, which was overhung above the PSG layer 113, as lift-off material. In addition, the PSG layer 113 is left residual on the semiconductor substrate 109 due to etching of the photoresist film 114 when the photoresist film 114 is used as lift-off material, to thereby form fine Al-Si layers 117, 118 and 119 in interconnection electrode forming holes 115 of the PSG layer 113. Therefore, the upper surface of the semiconductor substrate 109 was made flat, the Al layer 121 of second layer formed with the layer-insulating film 120 interposed was never opened, and bad effect which will be exerted to element characteristics because of flash occurrence at the end portion of the Al-Si interconnection electrode was prevented. In addition, the undercut amount of the PSG layer 113 under the photoresist film 114 could be easily controlled to reduce the pitch between interconnection electrodes 117, 118 and 119, thus enabling a bipolar integrated circuit of high integration and reliability to be produced.

There will be now described another example in which the present invention is employed in the process including the gettering step.

Example 2

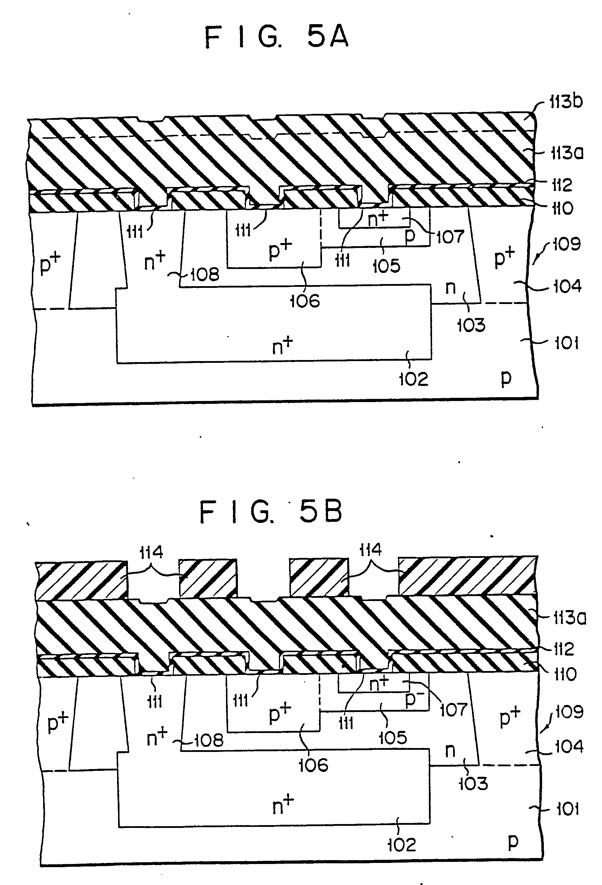

(I) As shown in Fig. 5A, an $n^+$-buried layer 102 was selectively formed in a p-type silicon substrate 101 and after an n-type epitaxial layer 103 was grown on the substrate 101, a $p^+$-type isolation region 104 was formed by selectively diffusing boron of high concentration into the n-type epitaxial layer 103, said region 104 serving to separte element regions. $n^+$-type collector region 108 which reached the $n^+$-buried layer 102 was formed by phosphorus diffusion. p-type internal base region 105 and $p^+$-type external base region 106 were formed by selectively implanting boron ions into element regions of the n-type epitaxial layer 103, while $n^+$-type emitter region 107 was formed by implanting arsenic ions into the internal base region 105, thus making a semiconductor substrate 109. A CVD-$SiO_2$ film 110 was coated as insulating film on the main surface of the semiconductor substrate 109, and after portions of the CVD-$SiO_2$ film 110 on the base, emitter and collector were further removed by photoetching to form contact holes 111, an undoped glass layer 112 ($SiO_2$ layer) was heaped up on the whole surface thereof by the vapor growth method to have a thickness of 50 nm (500 Å). A phosphorus-doped glass layer 113a (PSG layer) was then heaped up on the $SiO_2$ layer 112 by the vapor growth method to have a thickness of 1.2 μm and higher phosphorus concentration as it goes to the upper portion. Thereafter, phosphorus gettering was carried out for 50 minutes in a gas of $POCl_3$ at 900°C. A high-phosphorus-concentrated glass layer 113b was formed this time at a depth of 100—150 nm (1,000—1,500 Å) from the surface of the PSG layer 113a, and alkali metal contained in the semiconductor substrate 109, CVD-$SiO_2$ film 110 and PSG layer 113 was gettered.

(II) As shown in Fig. 5B, the high-phosphorus-concentrated glass layer 113b of the PSG layer 113a was removed by etching, and after the glass layer 113b was treated not to again diffuse gettered alkali metal, the portion of the PSG layer 113a except where interconnection electrode was to be formed was coated by a photoresist film 114 whose thickness was 1.0 μm and which was formed by photolithography. Same steps as those in the Example 1 were then performed successively to make a bipolar integrated circuit.

The Example 2 in which the PSG layer 113a was used as a layer for preventing phosphorus from being diffused to the semiconductor substrate 109 made it possible to produce a bipolar integrated circuit having shallow junction depth to the semiconductor substrate and excellent surface stability, and enabling phosphorus-gettering even if highly integrated.

The present invention can be employed in the manufacture of MOS integrated circuit as well as bipolar integrated circuit, as described in Examples 1 and 2.

**Claims**

1. A method of manufacturing a semiconductor device comprising forming an insulating film (110) on the main surface of a semiconductor substrate (101), parts of the insulating film (110) being selectively removed to form through-holes (111), depositing a glass layer (113) on the insulating film (110) and in the through-holes (111), the glass layer (113) having multi-layer structure consisting of at least two layers and in which etching rate becomes higher from the lower to the upper portions of the layer, coating a desired portion of the glass layer (113), where no interconnection electrode is to be formed, with a resist film (114), over-etching the glass layer (113) to make the resist film overhung using the resist film (114) as mask and to provide contact holes in the glass layer, forming a conductive layer (116a, 116b) on the whole surface of the structure so obtained, and removing the resist film (114) and lifting-off the portions of the conductive layer (116a) on the resist film (114) to thereby form an interconnection electrode.

2. A method of manufacturing a semiconductor device according to claim 1 wherein the glass layer (113) is made of impurity-added glass.

3. A method of manufacturing a semiconductor device according to claim 2 wherein the glass is one or more kinds of glass selected from a group consisting of phospho silicate glass, arseno silicate glass and boro silicate glass.

4. A method of manufacturing a semiconductor device according to any of claims 1 through 3 wherein etching of the glass layer (113) is carried out combining anisotropic etching with isotropic etching.

5. A method of manufacturing a semiconductor device according to claim 4 wherein the anisotropic etching is of reactive ion type, and the isotropic etching of wet type.

6. A method of manufacturing a semiconductor device according to any of claims 1 through 3 wherein the glass layer (113) is thicker than the conductive layer.

7. A method of manufacturing a semiconductor device according to claim 2 or 3 further including a step of depositing a thin no-impurity-added glass layer (112) on the insulating film (110) and in the through-holes (111) prior to deposition of the glass layer (113).

8. A method of manufacturing a semiconductor device according to any of claims 1 through 3 further including a step of gettering which comprises exposing the thus formed substrate in an atmosphere containing $POCl_3$ of high temperature after deposition of the glass layer (113), and a step of removing the surface portions of the glass layer by etching after the gettering step.

9. A method of manufacturing a semiconductor device according to claim 8 wherein etching of the glass layer (113) is carried out combining anisotropic etching with isotropic etching.

10. A method of manufacturing a semiconductor device according to claim 9 wherein the anisotropic etching is of reaction ion type, and the isotropic etching of wet type.

11. A method of manufacturing a semiconductor device according to claim 8, wherein the glass layer (113) is thicker than the conductive layer (116a, 116b).

12. A method of manufacturing a semiconductor device according to claim 8 further including a step of depositing a thin no-impurity-added glass layer (112) on the insulating film (110) and in the through-holes (111) prior to deposition of the impurity-added glass layer (113).

## Patentansprüche

1. Verfahren zur Herstellung einer Halbleitervorrichtung, gekennzeichnet durch Ausbilden eines Isolierfilms (110) auf der Hauptoberfläche eines Halbleitersubstrats (101), selektives Entfernen von Teilen des Isolierfilms (110) zur Bildung von Durchgangslöchern (111), Ablagern einer Glasschicht (113) auf den Isolierfilm (110) und in den Durchgangslöchern (111), wobei die Glasschicht (113) mehrlagig aufgebaut ist und aus mindestens zwei Lagen besteht und wobei ferner in der Glasschicht die Ätzgeschwindigkeit von ihrem unteren zu ihrem oberen Teil zunimmt, Beschichten eines gewünschten Teils der Glasschicht (113), in welchem keine Verbindungselektrode ausgebildet werden soll, mit einem Resistfilm (114), Überätzen der Glasschicht (113) zur Ausbildung des Resistfilmüberhangs unter Verwendung des Resistfilms (114) als Maske und zur Bereitstellung von Kontaktlöchern in der Glasschicht, Ausbilden einer Leiterschicht (116a, 116b) auf der Gesamtoberfläche des erhaltenen Gebildes, Entfernen des Resistfilms (114) und Abheben der Teile der Leiterschicht (116a) auf dem Resistfilm (114) zur Ausbildung einer Verbindungselektrode.

2. Verfahren nach Anspruch 1, dadurch gekennzeichnet, daß die Glasschicht (113) aus fremdatomhaltigem Glas besteht.

3. Verfahren nach Anspruch 2, dadurch gekennzeichnet, daß das Glas aus einem Phosphosilikatglas Arsensilikatglas und/oder Borsilikatglas besteht.

4. Verfahren nach Ansprüche 1 bis 3, dadurch gekennzeichnet, daß das Ätzen der Glasschicht (113) durch kombinierte anisotrope und isotrope Ätzung erfolgt.

5. Verfahren nach Anspruch 4, dadurch gekennzeichnet, daß als anisotrope Ätzung eine reaktive Ionenätzung und als isotrope Ätzung eine Naßätzung erfolgt.

6. Verfahren nach einem der Ansprüche 1 bis 3, dadurch gekennzeichnet, daß die Glasschicht (113) dicker ist als die Leiterschicht.

7. Verfahren nach Ansprüchen 2 oder 3, dadurch gekennzeichnet, daß zusätzlich vor der Ablagerung der Glasschicht (113) auf dem Isolierfilm (110) und in den Durchgangslöchern (111) eine dünne, keinen Fremdatomzusatz aufweisende Glasschicht (112) abgelagert wird.

8. Verfahren nach Ansprüche 1 bis 3, dadurch gekennzeichnet, daß zusätzlich eine Getterung erfolgt, indem das gebildete Substrat nach der Ablagerung der Glasschicht (113) einer $POCl_3$-enthaltenden Atmosphäre hoher Temperatur ausgesetzt wird, und daß die Oberflächenteile der Glasschicht nach der Getterung weggeätzt werden.

9. Verfahren nach Anspruch 8, dadurch gekennzeichnet, daß das Ätzen der Glasschicht (113) durch kombinierte anisotrope und isotrope Ätzung erfolgt.

10. Verfahren nach Anspruch 9, dadurch gekennzeichnet, daß als anisotrope Ätzung eine reaktive Ionenätzung und als isotrope Ätzung eine Naßätzung erfolgt.

11. Verfahren nach Anspruch 8, dadurch gekennzeichnet, daß die Glasschicht (113) dicker ist als die Leiterschicht (116a, 116b).

12. Verfahren nach Anspruch 8, dadurch gekennzeichnet, daß zusätzlich vor der Ablagerung der Glasschicht (113) auf dem Isolierfilm (110) und in den Durchgangslöcher (111) eine dünne, keinen Fremdatomzusatz aufweisende Glasschicht (112) abgelagert wird.

## Revendications

1. Procédé de fabrication d'un dispositif à semiconducteur caractérisé en ce qu'il consiste à former un film isolant (110) sur la surface principale d'un substrat semiconducteur (101), des parties du film isolant (110) étant sélectivement retirées pour former des trous de passage (111), à déposer une couche de verre (113) sur le film isolant (110) et dans les trous de passage (111), la couche de verre (113) ayant une structure multicouche constituée d'au moins deux couches et dans laquelle la vitesse d'attaque devient supérieure de la partie inférieure à la partie supérieure de la couche, à recouvrir une partie voulue de la couche de verre (113), où on ne doit pas former une électrode d'interconnexion, d'un film résistant (114), à attaquer par-dessus la couche de verre (113) pour rendre le film résistant en saillie en utilisant le film résistant (114) comme masque et pour obtenir des trous de contact dans la couche de verre, à former une couche conductrice (116a, 116b) sur toute la surface de la structure ainsi obtenue, et à retirer le film résistant (114) et à arracher les parties de la couche conductrice (116a) sur le film résistant (114) pour former ainsi une électrode d'interconnexion.

2. Procédé de fabrication d'un dispositif à semiconducteur selon la revendication 1, caractérisé en ce que la couche de verre (113) est constituée par un verre auquel sont ajoutées des impuretés.

3. Procédé de fabrication d'un dispositif à semiconducteur selon la revendication 2, caractérisé en ce que le verre est d'une ou de plusieurs sortes de verre choisies dans le groupe composé du verre au silicate de phosphore, du verre au silicate d'arsenic et du verre au silicate de bore.

4. Procédé de fabrication d'un dispositif à semiconducteur selon l'une quelconque des revendications 1 à 3, caractérisé en ce l'attaque de la couche de verre (113) est réalisée en combinant une attaque anisotropique et une attaque isotropique.

5. Procédé de fabrication d'un dispositif à semiconducteur selon la revendication 4, caractérisé en ce que l'attaque anisotropique est du type à ions réactifs, et en ce que l'attaque isotropique est du type à milieu humide.

6. Procédé de fabrication d'un dispositif à semiconducteur selon l'une quelconque des revendications 1 à 3, caractérisé en ce que la couche de verre (113) est plus épaisse que la couche conductrice.

7. Procédé de fabrication d'un dispositif à semiconducteur selon l'une quelconque des revendications 2 et 3, caractérisé en ce qu'il consiste en outre à déposer une couche de verre mince à laquelle ne sont pas ajoutées des impuretés (112) sur le film isolant (110) et dans les trous de passage (111) avant de déposer la couche de verre (113).

8. Procédé de fabrication d'un dispositif à semiconducteur selon l'une quelconque des revendications 1 à 3, caractérisé en ce qu'il consiste en outre à exécuter une opération de piégeage consistant à exposer le substrat ainsi formé dans une atmosphère contenant $POCl_3$ à température élevée après avoir déposé la couche de verre (113), et à retirer les parties de surface de la couche de verre par attaque après l'opération de piégeage.

9. Procédé de fabrication d'un dispositif à semiconducteur selon la revendication 8, caractérisé en ce que l'attaque de la couche de verre (113) est réalisée en combinant une attaque anisotropique et une attaque isotropique.

10. Procédé de fabrication d'un dispositif à semiconducteur selon la revendication 9, caractérisé en ce que l'attaque anisotropique est du type à ions réactifs, et en ce que l'attaque isotropique est du type à millieu humide.

11. Procédé de fabrication d'un dispositif à semiconducteur selon la revendication 8, caractérisé en ce que la couche de verre (113) est plus épaisse que la couche conductrice (116a, 116b).

12. Procédé de fabrication d'un dispositif à semiconducteur selon la revendication 8 consistant en outre à déposer une couche de verre mince à laquelle no sont pas ajoutées des impuretés (112) sur le film isolant (110) et dans les trous de passage (111) avant de déposer la couche de verre à laquelle sont ajoutées des impuretés (113).

## F I G. 1

## F I G. 2

# FIG. 3

# FIG. 4A

# FIG. 4B

# FIG. 4C

# F I G. 5A

# F I G. 5B